## Europäisches Patentamt

(19)  **European Patent Office**  (11) Veröffentlichungsnummer: **0 073 445**

**Office européen des brevets**  **B1**

(12)  # EUROPÄISCHE PATENTSCHRIFT

(45) Veröffentlichungstag der Patentschrift: (51) Int. Cl.⁴: **G 03 F 7/26**
**11.06.86**

(21) Anmeldenummer: **82107707.0**

(22) Anmeldetag: **23.08.82**

(54) Elektrochemisches Entwicklungsverfahren für Reproduktionsschichten.

(30) Priorität: **28.08.81  DE 3134054**

(43) Veröffentlichungstag der Anmeldung:
**09.03.83 Patentblatt 83/10**

(45) Bekanntmachung des Hinweises auf die Patenterteilung:
**11.06.86 Patentblatt 86/24**

(84) Benannte Vertragsstaaten:
**AT BE CH DE FR GB IT LI NL SE**

(73) Patentinhaber: **HOECHST AKTIENGESELLSCHAFT,
Postfach 80 03 20, D-6230 Frankfurt am Main 80 (DE)**

(72) Erfinder: **Pliefke, Engelbert, Dr., Fritz-Kalle-Strasse 34,
D-6200 Wiesbaden (DE)**

(56) Entgegenhaltungen:
**US - A - 2 117 294
US - A - 2 480 845**

**IBM TECHNICAL DISCLOSURE BULLETIN, Band 11, Nr. 12, Mai 1969, Seite 1735, New York, USA, A.J. McPHERSON et al.: "Removal of photoresist residue"**

LIBER, STOCKHOLM 1986

## Beschreibung

Die Erfindung betrifft ein Entwicklungsverfahren für Reproduktionsschichten mit einem Entwickler auf der Basis eines wäßrigen Elektrolyten gemäß Anspruch 1.

Lichtempfindliche Reproduktionsschichten werden beispielsweise bei der Herstellung von Offsetdruckformen oder von Photoresists (beides im weiteren Kopiermaterialien genannt) verwendet, d. h. sie werden im allgemeinen vom Verbraucher oder vom industriellen Hersteller auf einen Schichtträger aufgebracht. Als Schichtträger in diesen Kopiermaterialien werden Metalle wie Zink, Magnesium, Chrom, Kupfer, Messing, Stahl, Silicium, Aluminium oder Kombinationen dieser Metalle, Kunststoffolien, Papier oder ähnliche Materialien eingesetzt. Diese Schichtträger können ohne eine modifizierende Vorbehandlung, bevorzugt aber nach Durchführung einer Oberflächenmodifizierung wie einer mechanischen, chemischen und/oder elektrochemischen Aufrauhung, einer Oxidation und/oder einer Behandlung mit Hydrophilierungsmitteln (z. B. bei Trägern für Offsetdruckplatten) mit der lichtempfindlichen Reproduktionsschicht beschichtet werden. Die üblichen Reproduktionsschichten enthalten neben mindestens einer lichtempfindlichen Verbindung meist noch ein organisches Bindemittel (Harze o. ä.) und gegebenenfalls auch noch Weichmacher, Pigmente, Farbstoffe, Netzmittel, Sensibilisatoren, Haftvermittler, Indikatoren und andere übliche Hilfsmittel. Die Reproduktionsschichten werden nach ihrer Belichtung entwickelt, um aus ihnen ein Bild zu erzeugen, beispielsweise wird so eine Druckform oder ein Photoresist erhalten.

Ein Entwickler für negativ-arbeitende Reproduktionsschichten muß die nicht von elektromagnetischer Strahlung (z. B. Licht) getroffenen Schichtteile (die späteren Nichtbildstellen) aus der belichteten Schicht herauslösen können, ohne dabei die von der Strahlung getroffenen Teile (die späteren Bildstellen) der Schicht wesentlich zu beeinflussen. In der als ein repräsentatives Beispiel zu nennenden DE-OS 20 65 732 (= US-PS 3 867 147) werden als geeignete Entwickler beispielsweise aufgeführt: Wasser, Wasser/organische Lösemittel-Gemische, wäßrige Salzlösungen, wäßrige Säurelösungen, wäßrigalkalische Lösungen und unverdünnte organische Lösemittel, denen gegebenenfalls Tenside und/oder Hydrophilierungsmittel zugesetzt werden können. Die in den dortigen Beispielen hauptsächlich eingesetzten Entwickler enthalten Wasser, Na-laurylsulfat, Na-sulfat, Weinsäure und gegebenenfalls Benzylalkohol; andere Entwickler enthalten oder bestehen aus Isopropanol, n-Propanol, n-Propylacetat, Polyacrylsäure, 1,1,1-Trichlorethan, Aceton oder Ethylenglykolmonomethylether.

Ein Entwickler für positiv-arbeitende Reproduktionsschichten muß die von elektromagnetischer Strahlung getroffenen Schichtteile (die späteren Nichtbildstellen) aus der belichteten Schicht herauslösen können, ohne dabei die von der Strahlung nicht getroffenen Teile (die späteren Bildstellen) der Schicht wesentlich zu beeinflussen. In der als ein repräsentatives Beispiel zu nennenden DE-PS 12 00 133 (= US-PS 3 110 596) werden als geeignete Entwickler beispielsweise aufgeführt: alkalischwäßrige Lösungen von Phosphaten, Silikaten, Fluorosilikaten, Stannaten, Fluoroboraten oder Fluorotitanaten, die gegebenenfalls auch noch wasserlösliche Hydrokolloide oder organische Lösemittel enthalten können.

Ein "Entwickler" (besser Entschichtungsmittel) für elektrophotographisch arbeitende Reproduktionsschichten muß die nach a) Aufladung der einen Photoleiter enthaltenden Reproduktionsschicht, b) Belichtung der aufgeladenen Schicht und c) Betonerung und Fixierung des latenten elektrostatischen Bildes verbleibenden Nichtbildstellen aus der Schicht herauslösen können, ohne dabei die Bildstellen der Schicht wesentlich zu beeinflussen. In der als ein repräsentatives Beispiel zu nennenden DE-PS 11 17 391 werden als geeignete Flüssigkeiten für diesen Zweck aufgeführt: anorganische oder organischen Basen in wäßrigen Lösungen, denen auch noch organische Lösemittel zugefügt werden können; Beispiele sind: Octylamin in Polyethylenglykol, Morpholin, Natriumsilikat und Carboxymethylcellulose in Wasser; Monoethanolamin, Diethanolamin, Methanol, Ethylenglykol, Glycerin und Natriumsilikat; wäßrige NaOH-Lösung; wäßrige $NH_3$-Lösung mit Polyethylenglykol.

Die aus dem Stand der Technik bekannten Entwicklungsverfahren für belichtete Reproduktionsschichten arbeiten auf dem Prinzip einer Löslichkeitsdifferenzierung zwischen belichteten und unbelichteten Stellen und Teilen der Schicht. Oftmals weichen deshalb die pH-Werte geeigneter Entwickler erheblich vom Neutralen ab, und sie enthalten mehr oder weniger große Mengen an organischen Lösemitteln. Die Wirkstoffanteile in den bekannten Entwicklern - neben Wasser als erwünschtem Standardlösemittel - liegen im allgemeinen über etwa 5 bis 10 Gew.-%, d. h. sie stellen heute eine in steigendem Maße unerwünschte Abwasserbelastung dar. Außerdem werden in der Praxis für die unterschiedlichsten Reproduktionsschichten meist auch spezifisch wirkende Entwickler angeboten, die dann für andere Reproduktionsschichten ungeeignet sind. Typische Entwicklungszeiten liegen bei den bekannten Verfahren zwischen 15 und 120 sec.

Aufgabe der vorliegenden Erfindung ist es, ein Verfahren zum Entwickeln von Reproduktionsschichten aufzuzeigen, das mit Entwicklern auf wäßriger Basis ohne Zugabe von organischen Lösemitteln oder größeren Mengen anderer Hilfsstoffe bei verschiedensten Schichttypen durchgeführt werden kann.

Beim erfindungsgemäßen Verfahren werden die die Nichtbildstellen ergebenden Schichtteile durch elektrochemische Behandlung entfernt. Der wäßrige Elektrolyt weist einen pH-Wert Bereich von 2,0 bis 10,0 auf und enthält neben dem Hauptbestandteil Wasser als dissoziierte Verbindung insbesondere mindestens ein Salz einer organischen oder anorganischen Säure in einer Konzentration von 0,1 Gew.-% bis zur Sättigungsgrenze der Lösung an dem jeweiligen Salz oder er enthält Säuren Die Salzlösungen können auch als Puffersystem vorliegen und dann neben dem Salzanteil zusätzlich noch schwache Säuren (wie Essigsäure) oder schwache Basen (wie Ammoniak) enthalten; es kann auch zweckmäßig sein, den pH-Wert der Salzlösungen durch Zugabe von Säuren oder Basen zu verschieben, wobei jedoch die oben angegebenen pH-Werte nicht über- oder unterschritten werden sollten. Der wäßrige Elektrolyt kann als dissoziierte Verbindung anstelle der bevorzugt eingesetzten Salze auch Säuren (wie Essigsäure oder Borsäure) im angegebenen pH-Wert Bereich enthalten.

Zu den im erfindungsgemäßen Verfahren im wäßrigen Elektrolyten einsetzbaren Salzen gehören insbesondere solche, die als Kationen $Li^+$, $Na^+$, $K^+$, $NH_4^+$, $Al^{3+}$, $Fe^{2+}$, $Fe^{3+}$, $V^{5+}$, $Ca^{2+}$, $Mg^{2+}$, $Sr^{2+}$ oder $Ba^{2+}$ und als Anionen $SO_4^{2-}$, $S_2O_3^{2-}$, $SCN^-$, $CO_3^{2-}$, $CH_3COO^-$, $NO_3^-$ $NO_2^-$, $PO_4^{3-}$ $BO_2^-$, Polyphosphate, Polyborate, $F^-$, $Cl^-$, $Br^-$, $BF_4^-$ $N_3^-$, $VO_3^-$, Anionen von Alkylsulfaten (Schwefelsäuremonoalkylesteranionen) von $C_7$ bis $C_{16}$ oder deren entsprechende Hydrogensalze enthalten.

Der wäßrige Elektrolyt kann zur Vergleichmäßigung und Beschleunigung des erfindungsgemäßen Verfahrens noch ein Tensid enthalten, das von den oben aufgeführten dissoziierten Verbindungen verschieden ist und bevorzugt in einer Konzentration von 0,1 bis 5 Gew.-% zugegeben wird. Es können sowohl nichtionogene als auch anionogene oder kationogene Tenside Verwendung finden; sie sollten jedoch, insbesondere bei Durchführung des erfindungsgemäßen Verfahrens in Verarbeitungsmaschinen, eher von schwachschäumendem Typ sein. Als geeignete Tenside haben sich beispielsweise herausgestellt: Alkali-oder Ammoniumsalze der Schwefelsäuremonoalkylester mit Alkylgruppen von $C_7$ bis $C_{16}$, ethoxylierte Alkohole und Phenole, ethoxylierte Fettamine oder Blockpolymerisate auf Basis von Alkylenoxiden.

Nach dem erfindungsgemäßen Verfahren ist es also möglich, in wäßrigen Lösungen, die kein organisches Lösemittel oder andere größere Mengen an umweltbelastenden Hilfsstoffen enthalten, verschiedenste Arten von belichteten lichtempfindlichen Reproduktionsschichten bildmäßig zu differenzieren. Die dabei erreichbare Auflösung entspricht der konventioneller, nichtelektrochemisch anzuwendender Entwickler, die Entwicklungszeit liegt - abhängig von der Stromdichte und der Elektrolytart und -konzentration - im allgemeinen bei etwa 0,5 bis 30 sec. Das Wirkungsprinzip des erfindungsgemäßen Verfahrens liegt wahrscheinlich in der unterschiedlichen Ionenpermeabilität und/oder Löslichkeit von belichteten und unbelichteten Stellen und Teilen der Reproduktionsschichten begründet. Die Art des eingesetzten Trägers für die Reproduktionsschichten beeinflußt im wesentlichen nur die Entwicklungsgeschwindigkeit, aber - bei Verwendung eines geeigneten Elektrolyen - nicht das Endergebnis des Entwicklungsvorgangs.

Da der pH-Wert eines ungepufferten wäßrigen Elektrolyten sich aufgrund (elektro)chemischer Veränderungen an seinen Komponenten während der Ausführung des erfindungsgemäßen Verfahrens verändern kann, empfiehlt sich bei Mehrfachverwendung des wäßrigen Elektrolyten der Einsatz eines zusätzlichen Puffersystems.

Die Konzentration des wäßrigen Elektrolyten an dissoziierter Verbindung kann zwischen 0,1 Gew.-%, insbesondere 1 Gew.-% und der jeweiligen Sättigungskonzentration der dissoziierten Verbindung liegen, im allgemeinen sind bereits Konzentrationen bis zu 5 Gew.-% ausreichend. Wenn die Konzentration des wäßrigen Elektrolyten unter 0,1 Gew.-% liegt, dann ist meistens die Leitfähigkeit der Lösung zu niedrig, so daß die resultierende Stromdichte zu gering wird, um eine rasch ablaufende Entwicklung zu erzielen. Die Temperatur des wäßrigen Elektrolyten könnte von Raumtemperatur bis zum Siedepunkt des Elektrolytsystems reichen; es wird jedoch eine Temperatur von 20° bis 70°C eingehalten. Ein Durchmischen des wäßrigen Elektrolyten während der Durchführung des erfindungsgemäßen Verfahrens ist im allgemeinen nicht erforderlich.

Das erfindungsgemäße Verfahren wird mit Gleichstrom oder Wechselstrom verschiedener Frequenz und Modulation durchgeführt, es kann auch gepulster Gleichstrom eingesetzt werden. Die Stromdichte liegt im Bereichs von 1 bis 100 $A/dm^2$. Außerhalb dieses Bereichs wird die Aufheizung des wäßrigen Elektrolyten zu stark und/oder der Entwicklungsprozeß kann hinsichtlich der Dauer oder der Qualität negativ beeinflußt werden. Die Stromdichte steigt zu Beginn der elektrolytischen Entwicklung an, verbleibt eine gewisse Zeit auf einer Höhe und steigt gegen Ende des Entwicklungsvorgangs wieder leicht an.

Während des elektrochemischen Entwicklungsvorganges wird in der Regel an der Kathode Wasserstoff durch Entladung von $H^+$ ($H_3O^+$)-Ionen freigesetzt. Es wird angenommen, daß dadurch der pH-Wert lokal stark ansteigt und die Ablösung des löslicheren Teils der bildmäßig belichteten Reproduktionsschicht bewirken kann. Durch den dabei gelegentlich entstehenden hohen pH-Wert kann in einigen wäßrigen Elektrolyten der Träger der Reproduktionsschicht stellenweise angegriffen werden; der eigentliche Entwicklungsprozeß wird jeodch dadurch nicht beeinflußt und dieser Angriff kann - sofern überhaupt erforderlich - durch Zusatz von Korrosionsinhibitoren vermindert werden. Eine mangelnde Benetzung der Reproduktionsschichten durch den wäßrigen Elektrolyten kann gelegentlich zum Auftreten von Schichtresten in den an sich bildfreien Stellen führen, dies kann aber durch Einsatz eines für die betreffende Schicht geeigneten Tensids oder kurzes "Einweichen" der Platte mit dem wäßrigen Elektrolyten vor der eigentlichen elektrochemischen Entwicklung vermieden werden.

In einer bevorzugten Ausführungsform des erfindungsgemäßen Verfahrens wird die zu behandelnde Reproduktionsschicht, die insbesondere als Teil eines Kopiermaterials mit einem elektrisch leitfähigen Trägermaterial vorliegt, durch Eintauchen mit der wäßrigen Elektrolytlösung kontaktiert. Dabei sollte eine Kante des Trägermaterials aus der Oberfläche des Elektrolytbades herausragen, an diesem Teil kann dann ein Stromanschluß befestigt werden. Eine andere Möglichkeit der Stromzufuhr liegt in der Kontaktierung über die unbeschichtete Trägermaterialrückseite. Die Gegenelektrode sollte aus einem Material bestehen, das gegenüber dem wäßrigen Elektrolyten beständig ist, beispielsweise aus rostfreiem Stahl oder Graphit, und sollte vorzugsweise die Form eines Stabes, eines Siebes oder einer Platte haben und gegenüber dem Kopiermaterial insbesondere in einem gleichmäßigen Abstand angeordnet sein, damit eine gleichmäßige Stromdichte auf der ganzen Oberfläche des bildmäßig belichteten Kopiermaterials vorhanden ist. Die unbeschichtete Rückseite des zu entwickelnden Kopiermaterials sollte vorzugsweise an einem nicht leitenden Material anliegen, um einen unnötigen Verbrauch an elektrischer Energie zu vermeiden. Eine andere Möglichkeit liegt in der Abschottung der Materialrückseite, wobei die Platte im Elektrolytbad-Behälter in dichten Nuten geführt wird.

In einer anderen Ausführungsform des erfindungsgemäßen Verfahrens wird ein mit wäßrigem Elektrolyten getränktes Tuch angewendet, das zwischen dem belichteten Kopiermaterial und der Gegenelektrode angeordnet wird. Nach der Entwicklung kann das Tuch ohne größere Umweltbelastung weggeworfen werden, da der pH-Wert des Elektrolyten in der Regel um den Neutralpunkt liegt oder so eingestellt werden kann.

Die zu entwickelnde Reproduktionsschicht liegt insbesondere als Teil (lichtempfindliche Schicht) einer Offsetdruckplatte oder als auf ein Trägermaterial aufgebrachter Resist (Photoresistschicht) vor. Als Trägermaterialien kommen zweckmäßig elektrisch leitfähige Trägermaterialien in Frage, wozu beispielsweise solche auf der Basis von Zink, Chrom, Magnesium, Kupfer, Messing, Stahl, Silicium, Aluminium oder Kombinationen dieser Metalle zählen. Diese können ohne eine spezielle modifizierende Vorbehandlung mit einer geeigneten Reproduktionsschicht versehen werden, bevorzugt wird diese Beschichtung jedoch erst nach einer Oberflächenmodifizierung wie einer mechanischen, chemischen oder elektrochemischen Aufrauhung, einer Oxidation und/oder einer Behandlung mit Hydrophilierungsmitteln (insbesondere bei Trägern für Offsetdruckplatten) durchgeführt.

Als besonders geeignete Substrate zur Herstellung von Offsetdruckplatten zählen solche aus Aluminium oder einer seiner Legierungen. Dazu gehören beispielsweise:

- "Reinaluminium" (DIN-Werkstoff Nr. 3.0255), d. h. bestehend aus $\geq$ 99,5 % Al und den folgenden zulässigen Beimengungen von (maximale Summe von 0,5 %) 0,3 % Si, 0,4 % Fe, 0,03 % Ti, 0,02 % Cu, 0,07 % Zn und 0,03 % Sonstigem, oder

- "Al-Legierung 3003" (vergleichbar mit DIN-Werkstoff Nr. 3.0515), d. h. bestehend aus $\geq$ 98,5 % Al, den Legierungsbestandteilen 0 bis 0,3 % Mg und 0,8 bis 1,5 % Mn und den folgenden zulässigen Beimengungen von 0,5 % Si, 0,5 % Fe, 0,2 % Ti, 0,2 % Zn, 0,1 % Cu und 0,15 % Sonstigem.

Die in der Praxis sehr häufig anzutreffenden Aluminiumträgermaterialien für Druckplatten werden im allgemeinen vor Aufbringen der lichtempfindlichen Schicht noch mechanisch (z. B. durch Bürsten und/oder mit Schleifmittel-Behandlungen), chemisch (z. B. durch Ätzmittel) oder elektrochemisch (z. B. durch Wechselstrombehandlung in wäßrigen HCl- oder $HNO_3$-Lösungen) aufgerauht. Die mittlere Rauhtiefe $R_z$ der aufgerauhten Oberfläche liegt dabei im Bereich von etwa 1 bis 15 μm, insbesondere im Bereich von 4 bis 8 μm.

Die Rauhtiefe wird nach DIN 4768 in der Fassung vom Oktober 1970 ermittelt, die Rauhtiefe $R_z$ ist dann das arithmetische Mittel aus den Einzelrauhtiefen fünf aneinandergrenzender Einzelmeßstrecken.

Nach dem bevorzugt angewendeten elektrochemischen Aufrauhverfahren schließt sich dann in einer weiteren, gegebenenfalls anzuwendenden Verfahrensstufe eine anodische Oxidation des Aluminiums an, um beispielsweise die Abriebs- und Haftungseigenschaften der Oberfläche des Trägermaterials zu verbessern. Zur anodischen Oxidation können die üblichen Elektrolyte wie $H_2SO_4$, $H_3PO_4$, $H_2C_2O_4$, Amidosulfonsäure, Sulfobernsteinsäure, Sulfosalicylsäure oder deren Mischungen eingesetzt werden. Es wird beispielsweise auf folgende Standardmethoden für den Einsatz von $H_2SO_4$ enthaltenden wäßrigen Elektrolyten für die anodische Oxidation von Aluminium hingewiesen (s. dazu z. B. M. Schenk, Werkstoff Aluminium und seine anodische Oxydation, Francke Verlag - Bern, 1948, Seite 760; Praktische Galvanotechnik, Eugen G. Leuze Verlag - Saulgau, 1970, Seiten 395 ff und Seiten 518/519; W. Hübner und C. T.

Speiser, Die Praxis der anodischen Oxidation des Aluminiums, Aluminium Verlag - Düsseldorf, 1977, 3. Auflage, Seiten 137 ff):

- Das Gleichstrom-Schwefelsäure-Verfahren, bei dem in einem wäßrigen Elektrolyten aus üblicherweise ca. 230 g $H_2SO_4$ pro 1 l Lösung bei 10° bis 22°C und einer Stromdichte von 0,5 bis 2,5 A/dm² während 10 bis 60 min anodisch oxidiert wird. Die Schwefelsäurekonzentration in der wäßrigen Elektrolytlösung kann dabei auch bis auf 8 bis 10 Gew.-% $H_2SO_4$ (ca. 100 g $H_2SO_4$/l) verringert oder auch auf 30 Gew.-% (365 g $H_2SO_4$/l) und mehr erhöht werden.

- Die "Hartanodisierung" wird mit einem wäßrigen, $H_2SO_4$ enthaltenden Elektrolyten einer Konzentration von 166 g $H_2SO_4$/l (oder ca. 230 g $H_2SO_4$/l) bei einer Betriebstemperatur von 0° bis 5°C, bei einer Stromdichte von 2 bis 3 A/dm², einer steigenden Spannung von etwa 25 bis 30 V zu Beginn und etwa 40 bis 100 V gegen Ende der Behandlung und während 30 bis 200 min durchgeführt.

Neben den im vorhergehenden Absatz bereits genannten Verfahren zur anodischen Oxidation von Druckplatten-Trägermaterialien können beispielsweise noch die folgenden Verfahren zum Einsatz kommen: die anodische Oxidation von Aluminium in einem wäßrigen $H_2SO_4$ enthaltenden Elektrolyten, dessen $Al^{3+}$-Ionengehalt auf Werte von mehr als 12 g/l eingestellt wird (nach der DE-OS 28 11 396 = US-PS 4 211 619), in einem wäßrigen, $H_2SO_4$ und $H_3PO_4$ enthaltenden Elektrolyten (nach der DE-OS 27 07 810 = US-PS 4 049 504) oder in einem wäßrigen, $H_2SO_4$, $H_3PO_4$ und $Al^{3+}$-Ionen enthaltenden Elektrolyten (nach der DE-OS 28 36 803 = US-PS 4 229 226). Zur anodischen Oxidation wird bevorzugt Gleichstrom verwendet, es kann jedoch auch Wechselstrom oder eine Kombination dieser Stromarten (z. B. Gleichstrom mit überlagertem Wechselstrom) eingesetzt werden. Die Schichtgewichte an Aluminiumoxid bewegen sich im Bereich von 1 bis 10 g/m², entsprechend einer Schichtdicke von etwa 0,3 bis 3,0 μm.

Der Stufe einer anodischen Oxidation des Druckplatten-Trägermaterials aus Aluminium können auch eine oder mehrere Nachbehandlungsstufen nachgestellt werden. Dabei wird unter Nachbehandeln insbesondere eine hydrophilierende chemische oder elektrochemische Behandlung der Aluminiumoxidschicht verstanden, beispielsweise eine Tauchbehandlung des Materials in einer wäßrigen Polyvinylphosphonsäure-Lösung nach der DE-PS 16 21 478 (= GB-PS 1 230 447), eine Tauchbehandlung in einer wäßrigen Alkalisilikat-Lösung nach der DE-AS 14 71 707 (= US-PS 3 181 461) oder eine elektrochemische Behandlung (Anodisierung) in einer wäßrigen Alkalisilikat-Lösung nach der DE-OS 25 32 769 (= US-PS 3 902 976). Diese Nachbehandlungsstufen dienen insbesondere dazu, die bereits für viele Anwendungsgebiete ausreichende Hydrophilie der Aluminiumoxidschicht noch zusätzlich zu steigern, wobei die übrigen bekannten Eigenschaften dieser Schicht mindestens erhalten bleiben.

Als lichtempfindliche Reproduktionsschichten sind grundsätzlich alle Schichten geeignet, die nach dem Belichten, gegebenenfalls mit einer nachfolgenden Entwicklung und/oder Fixierung eine bildmäßige Fläche liefern, von der gedruckt werden kann und/oder die ein Reliefbild einer Vorlage darstellt. Sie werden entweder beim Hersteller von vorsensibilisierten Druckplatten oder von sogenannten Trockenresists oder direkt vom Verbraucher auf eines der üblichen Trägermaterialien aufgebracht. Zu den lichtempfindlichen Reproduktionsschichten zählen solche, wie sie z. B. in "Light-Sensitive Systems" von Jaromir Kosar, John Wiley & Sons Verlag, New York 1965 beschrieben werden: die ungesättigte Verbindungen enthaltenden Schichten, in denen diese Verbindungen beim Belichten isomerisiert, umgelagert, cyclisiert oder vernetzt werden (Kosar, Kapitel 4); die photopolymerisierbare Verbindungen enthaltenden Schichten, in denen Monomere oder Präpolymere gegebenenfalls mittels eines Initiators beim Belichten polymerisieren (Kosar, Kapitel 5); und die o-Diazo-chinone wie Naphthochinondiazide, p-Diazo-chinone oder Diazoniumsalz-Kondensate enthaltenden Schichten (Kosar, Kapitel 7). Zu den geeigneten Schichten zählen auch die elektrophotographischen Schichten, d. h. solche die einen anorganischen oder organischen Photoleiter enthalten. Außer den lichtempfindlichen Substanzen können diese Schichten selbstverständlich noch andere Bestandteile wie z. B. Harze, Farbstoffe oder Weichmacher enthalten. Insbesondere können die folgenden lichtempfindlichen Massen oder Verbindungen bei der Beschichtung der Trägermaterialien eingesetzt werden:

Positiv arbeitende o-Chinondiazid-, bevorzugt o-Naphthochinondiazid-Verbindungen, die beispielsweise in den DE-PSen 854 890, 865 109, 879 203, 894 959, 938 233, 1 109 521, 1 144 705, 1 118 606, 1 120 273 und 1 124 817 beschrieben werden.

Negativ arbeitende Kondensationsprodukte aus aromatischen Diazoniumsalzen und Verbindungen mit aktiven Carbonylgruppen, bevorzugt Kondensationsprodukte aus Diphenylamindiazoniumsalzen und Formaldehyd, die beispielsweise in den DE-PSen 596 731, 1 138 399, 1 138 400, 1 138 401, 1 142 871, 1 154 123, den US-PSen 2 679 498 und 3 050 502 und der GB-PS 712 606 beschrieben werden.

Negativ arbeitende Mischkondensationsprodukte aromatischer Diazoniumverbindungen, beispielsweise nach der DE-OS 20 24 244, die mindestens je eine Einheit der allgemeinen Typen A(-D)$_n$ und B verbunden durch ein zweibindiges, von einer kondensationsfähigen Carbonylverbindung abgeleitetes Zwischenglied aufweisen. Dabei sind diese Symbole wie folgt definiert: A ist der Rest einer mindestens zwei aromatische carbo- und/oder heterocyclische Kerne enthaltenden Verbindung, die in saurem Medium an mindestens einer Position zur Kondensation mit einer aktiven Carbonylverbindung befähigt ist. D ist eine an ein aromatisches Kohlenstoffatom von A gebundene Diazoniumsalzgruppe; n ist eine ganze Zahl von 1 bis 10; und B der Rest einer von Diazoniumgruppen freien Verbindung, die in saurem Medium an mindestens einer Position des Moleküls zur Kondensation mit einer aktiven Carbonylverbindung befähigt ist.

Positiv arbeitende Schichten nach der DE-OS 26 10 842, die eine bei Bestrahlung Säure abspaltende Verbindung, eine Verbindung, die mindestens eine durch Säure abspaltbare C-O-C-Gruppe aufweist (z. B. eine Orthocarbonsäureestergruppe oder eine Carbonsäureamidacetalgruppe) und gegebenenfalls ein Bindemittel enthalten.

Negativ arbeitende Schichten aus photopolymerisierbaren Monomeren, Photoinitiatoren, Bindemitteln und gegebenenfalls weiteren Zusätzen. Als Monomere werden dabei beispielsweise Acryl- und Methacrylsäureester oder Umsetzungsprodukte von Diisocyanaten mit Partialestern mehrwertiger Alkohole eingesetzt, wie es beispielsweise in den US-PSen 2 760 863 und 3 060 023 und den DE-OSen 20 64 079 und 23 61 041 beschrieben wird. Als Photoinitiatoren eignen sich u. a. Benzoin, Benzoinether, Mehrkernchinone, Acridinderivate, Phenazinderivate, Chinoxalinderivate, Chinazolinderivate oder synergistische Mischungen verschiedener Ketone. Als Bindemittel können eine Vielzahl löslicher organischer Polymere Einsatz finden, z. B. Polyamide, Polyester, Alkydharze, Polyvinylalkohol, Polyvinylpyrrolidon, Polyethylenoxid, Gelatine oder Celluloseether.

Negativ arbeitende Schichten gemäß der DE-OS 30 36 077, die als lichtempfindliche Verbindung ein Diazoniumsalz-Polykondensationsprodukt oder eine organische Azidoverbindung und als Bindemittel ein hochmolekulares Polymeres mit seitenständigen Alkenylsulfonyl- oder Cycloalkenylsulfonylurethan-Gruppen enthalten.

Es können auch photohalbleitende Schichten, wie sie z. B. in den DE-PSen 11 17 391, 15 22 497, 15 72 312, 23 22 046 und 23 22 047 beschrieben werden, auf die Trägermaterialien aufgebracht werden, wodurch hochlichtempfindliche, elektrophotographische Schichten entstehen.

In den folgenden Beispielen sind die %-Angaben - wenn nicht eine andere Angabe vorliegt - auf das Gewicht bezogen. Gew.-Teile verhalten sich zu Vol.-Teilen wie g zu cm³. Die zu entwickelnden Reproduktionsschichten befinden sich auf leitfähigen Trägern und werden - falls nicht anders beschrieben - als Kathode in einem Gleichstromkreis geschaltet. Die Elektrolyttemperatur beträgt - wenn keine andere Angabe vorliegt - 25 bis 30°C, der Abstand des zu entwickelnden Kopiermaterials von der Gegenelektrode beträgt in der Regel 2,75 cm. Der Verlauf der Stromdichte kann in der Regel wie folgt dargestellt werden (s. auch Beispiel 67): Die Stromdichte steigt während einiger sec zunächst auf einen bestimmten Wert an, verbleibt einige sec auf diesem Stand und kann gegen Ende der elektrolytischen Entwicklung erneut leicht ansteigen. Die Entwicklungszeit beträgt - wenn nicht eine andere Angabe zu finden ist - etwa 3 bis 15 sec. Wenn keine speziellen Bemerkungen angegeben sind, sind die entwickelten bzw. entschichteten Kopiermaterialien praxisgerecht

**Beispiel 1**

Auf eine elektrochemisch aufgerauhte und anodisch oxidierte Aluminiumfolie wird durch Fließbeschichtung mit einer Breitschlitzdüse die folgende positiv-arbeitende lichtempfindliche Lösung aufgebracht:

6,6 Gew.-Teile Kresol-Formaldehyd-Novolak (mit dem Erweichungsbereich von 105° - 120°C nach DIN 53 181)

1,1 Gew.-Teile des 4-(2-Phenyl-prop-2-yl)-phenylesters der Naphthochinon-(1,2)-diazid-(2)-sulfonsäure-(4)

0,6 Gew.-Teile 2,2'-Bis-[naphthochinon-(1,2)-diazid-(2)-sulfonyloxy-(5)]-dinaphthyl-(1,1')-methan

0,24 Gew.-Teile Naphthochinon-(1,2)-diazid-(2)-sulfo-chlorid-(4)

0,08 Gew.-Teile Kristallviolett

91,36 Gew.-Teile Gemisch aus 4 Vol.-Teilen Ethylenglykolmonomethylether, 5 Vol.-Teilen Tetrahydrofuran und 1 Vol.-Teil Essigsäurebutylester

Diese Platte wird bildmäßig belichtet und dann in einer wäßrigen Lösung mit einem Gehalt an 3 % Lithiumsulfat und 1 % Natrium-octylsulfat (Natriumsalz des Schwefelsäuremonoocytylesters) bei einem pH-Wert von 3,5 mit 20 V für 11 bis 14 sec elektrochemisch entwickelt.

**Beispiel 2**

Eine mit Stahlbürsten mechanisch aufgerauhte Aluminiumfolie wird mit folgender Lösung beschichtet und anschließend im Trockenkanal bei Temperaturen bis 100°C getrocknet:

1,15 Gew.-Teile des Veresterungsproduktes aus I Mol 2,3,4-Trihydroxybenzophenon und 2 Mol Naphthochinon-(1,2)-diazid-(2)-5-sulfonsäurechlorid

7,15 Gew.-Teile eines Phenol-Formaldehyd-Novolaks (mit 14 % phenolischen OH-Gruppen und einem Erweichungspunkt von 110° - 120°C nach DIN 53 181)

0,64 Gew.-Teile 2,2'-Bis-[naphthochinon-(1,2)-diazid-(2)-sulfonyloxy-(5)]-dinaphthyl-(1,1')-methan

0,15 Gew.-Teile Kristallviolett

0,08 Gew.-Teile Sudangelb GGN (C. I. 11021)

92,25 Gew. Teile Gemisch aus 40 Vol.-Teilen Ethylenglykolmonomethylether und 50 Vol.-Teilen Tetrahydrofuran

Diese Platte wird nach der bildmäßigen Belichtung in einer wäßrigen Lösung mit einem Gehalt an 3 % Lithiumsulfat und 1 % Natrium-octylsulfat bei einem pH-Wert von 7,5 mit 60 V für 1 bis 3 sec elektrochemisch entwickelt.

**Beispiel 3 und Vergleichsbeispiel V 1**

Eine negativ-arbeitende lichtempfindliche Lösung, bestehend aus

14,00 Gew.-Teilen eines Mischpolymerisats aus Methylmethacrylat und Methacrylsäure mit einem mittleren Molekulargewicht von 40000 und einer Säurezahl von 90 bis 115

14,00 Gew.-Teilen 1,1,1-Trimethylol-ethan-triacrylat

2,00 Gew.-Teilen 1,6-Dihydroxy-ethoxy-hexan

0,50 Gew.-Teilen 9-p-Hydroxyphenylacridin

130,00 Gew.-Teilen Ethylenglykolmonoethylether

wird auf eine elektrochemisch aufgerauhte, anodisch oxidierte und mit einer wäßrigen Polyvinylphosphonsäure-Lösung hydrophilierte Aluminiumfolie aufgetragen und nach bildmäßiger Belichtung in einer wäßrigen Lösung mit einem Gehalt an 3 % Lithiumsulfat und 1 % Natrium-octylsulfat bei einem pH-Wert von 3,5 für 5 bis 10 sec bei 10 V elektrochemisch entwickelt. Die erhaltene Qualität der Druckform ist mit der nach einer nicht-elektrochemischen Entwicklung in

15,00 Gew.-Teilen Natriummetasilikat " 9 H$_2$O

3,00 Gew.-Teilen Polyethylenglykol eines mittleren Molekulargewichts von etwa 6000

0,6 Gew.-Teilen Lävulinsäure

0,3 Gew.-Teilen Strontiumhydroxid " 8 H$_2$O

1000,00 Gew.-Teilen Wasser

vergleichbar, wobei die Entwicklungszeit im Vergleichsbeispiel jedoch etwa 60 sec betrug.

**Beispiel 4**

Auf eine elektrochemisch aufgerauhte, anodisch oxidierte und mit einer wäßrigen Polyvinylphosphonsäure-Lösung hydrophilierte Aluminiumfolie wird folgende negativarbeitende lichtempfindliche Schicht aufgebracht:

26,75 Gew.-Teile einer 8 %igen Lösung des Umsetzungsproduktes eines Polyvinylbutyrals (mit einem Molekulargewicht von 70000 bis 80000, bestehend aus 71 % Vinylbutyral-, 2 % Vinylacetat- und 27 % Vinylalkohol-Einheiten) mit Propenylsulfonylisocyanat

2,14 Gew.-Teile 2,6-Bis-(4-azido-benzol)-4-methylcyclohexanon

0,23 Gew.-Teile Rhodamin 6 GDN extra

0,21 Gew.-Teile 2-Benzoylmethylen-I-methyl-ß-naphthothiazin

100 Vol.-Teile Ethylenglykolmonomethylether

50 Vol.-Teile Tetrahydrofuran.

Die elektrochemische Entwicklung erfolgt in einer wäßrigen Lösung mit einem Gehalt an 1,5 % Lithiumcarbonat und 1 % Natrium-octylsulfat bei einem pH-Wert von 8 mit 60 V und während 10 bis 12 sec. Nach dem Ausreiben wird eine für die Praxis ausreichende Druckform erhalten.

**Beispiel 5**

Eine elektrophotographisch-arbeitende Schicht bestehend aus:

10,00 Gew.-Teilen 2-Vinyl-5-(4'-diethylaminophenyl)-4-(2'-chlorphenyl)-oxazol

10,00 Gew.-Teilen eines Mischpolymerisats aus Styrol und Maleinsäureanhydrid (mit einem Erweichungspunkt von 210°C)

0,02 Gew.-Teilen Rhodamin FB (C. I. 45 170)

300,00 Gew.-Teilen Ethylenglykolmonomethylether

wird auf eine elektrochemisch aufgerauhte, anodisch oxidierte und mit einer wäßrigen Polyvinylphosphonsäure-Lösung hydrophilierte Aluminiumfolie aufgetragen. Diese Schicht wird im Dunkeln mit Hilfe einer Corona auf etwa 400 Volt negativ aufgeladen. Die aufgeladene Platte wird in einer Reprokamera belichtet und anschließend nach in der Elektrophotographie üblichen Methoden betonert und fixiert. Die Platte kann dann in einer 1,5 %igen wäßrigen Lithiumcarbonat-Lösung mit einem Gehalt an 1 % Natriumoytylsulfat mit 60 V während 8 bis 12 sec bei einem pH-Wert von 8 und einer Temperatur von 50°C nach einer vorhergehenden nichtelektrolytischen Standzeit in der Lösung von 30 sec an den Nichtbildstellen elektrochemisch entschichtet werden.

**Beispiel 6**

Die elektrophotographisch-arbeitende Schicht aus Beispiel 5 wird auf einen durch trockenes Bürsten mechanisch aufgerauhten Aluminiumträger aufgebracht und nach den Angaben des Beispiels 5 weiterverarbeitet. Die Entschichtung erfolgt im gleichen Elektrolyten unter gleichen Bedingungen, jedoch ohne eine vorhergehende nichtelektrochemische Einwirkungsphase.

**Beispiel 7**

Ein elektrochemisch aufgerauhter, anodisch oxidierter und mit einer wäßrigen Lösung von Polyvinylphosphonsäure hydrophilierter Aluminiumträger wird mit folgender negativarbeitenden lichtempfindlichen Lösung beschichtet:

1,0 Gew.-Teile Polykondensationsprodukt aus 1 Mol 3-Methoxy-diphenylamin-4-diazoniumsulfat und 1 Mol 4,4'-Bis-methoxymethyl-diphe-nylether, ausgefällt als Salz der Mesitylensulfonsäure,

1,8 Gew.-Teile nichtplastifiziertes Harnstoffharz (mit einer Viskosität in 65 %iger Lösung in Butanol/Xylol bei 20°C von ca. 6000 mPas und einer Säurezahl unterhalb 3)

0,4 Gew.-Teile Kristallviolett

98,0 Gew.-Teile Ethylenglykolmonomethylether

Die elektrochemische Entwicklung erfolgt in einer wäßrigen Lösung mit einem Gehalt an 3 % Natriumphosphat und 3 % eines ethoxylierten Isotridecylalkohols mit 8 Ethylenoxid-Einheiten bei einem pH-Wert von 7 durch Anlegen von 20 V für 5 bis 7 sec (der pH-Wert wird mit H$_3$PO$_4$ eingestellt). Die Platte wird bildmäßig entwickelt, aber die Bildstellen werden im Vollton leicht angegriffen.

**Beispiel 8**

Eine positiv-arbeitende lichtempfindliche Lösung, bestehend aus:

25,0 Gew.-Teilen Bis-(5-ethyl-5-butyl-1,3-dioxan-2-yl)-ether des 2-Ethyl-2-butyl-1,3-propandiols

71,0 Gew.-Teilen eines Kresol-Formaldehyd-Novolaks

0,7 Gew.-Teilen Kristallviolett-Base

3,0 Gew.-Teilen 2-(Acenaphth-5-yl)-4,6-bis-trichlormethyl-s-triazin

900,0 Gew.-Teilen Ethylenglykolmonomethylether

wird auf eine elektrochemisch aufgerauhte und anodisch oxidierte Aluminiumfolie aufgetragen. Nach der Relichtung kann die Folie in einer wäßrigen Lösung mit einem Gehalt an 3 % Lithiumsulfat mit 1 % Natrium-octylsulfat mit 15 bis 20 V Spannung bei einem pH-Wert von 3,5 elektrochemisch entwickelt werden.

**Beispiel 9**

Die Platte aus Beispiel 3 wird in 6 %iger wäßriger Natriumlaurylsulfat-Lösung bei einem pH-Wert von 4 elektrochemisch entwickelt.

**Beispiel 10** Eine durch Trockenbürstung mechanisch aufgerauhte und anodisch oxidierte Aluminiumfolie wird mit einer positivarbeitenden lichtempfindlichen Lösung aus folgenden Bestandteilen beschichtet:

1,6 Gew.-Teile des Veresterungsproduktes aus 1 Mol 2,3,4-Trihydroxy-benzophenon und 2 Mol Naphthochinon-(1,2)-diazid-(2)-5-sulfonsäurechlorid

0,9 Gew.-Teile 2,2′-Bis-[naphthochinon-(1,2)-diazid-(2)-sulfonyloxy-(5)]-dinaphthyl-(1,1′)-methan

6,4 Gew.-Teile Kresol-Formaldehyd-Novolak (mit dem Erweichungspunkt von 105° - 120°C nach DIN 53 181)

90,1 Gew.-Teile Gemisch aus 4 Vol.-Teilen Ethylenglykolmonomethylether, 5 Vol.-Teilen Tetrahydrofuran und 1 Vol.-Teil Essigsäurebutylester

Diese beschichtete Folie wird in einer wäßrigen Lösung mit einem Gehalt an 3 % Ammoniumphosphat und 1 % Natriumoctylsulfat bei einem pH-Wert von 7,5 (mit $H_3PO_4$ eingestellt) elektrochemisch entwickelt.

**Beispiele 11 bis 61**

Eines der vorher beschriebenen Kopiermaterialien wird in der in der folgenden Tabelle angegebenen Lösung elektrochemisch entwickelt. Die Bedingungen sind ebenfalls der Tabelle zu entnehmen.

Tabelle

| Bsp. | Typ des Kopiermaterials | wäßriger Elektrolyt | | Tensid | | pH-Wert | Bemerkungen |
|---|---|---|---|---|---|---|---|
| | | Typ | Konz. (%) | Typ | Konz. (%) | | |
| 11 | lichtempfindliche Schicht nach Bsp.1, Träger zusätzlich mit wäßriger PVPS-Lösung hydrophiliert | Na-thiosulfat | 3 | Na-octylsulfat | 1 | 3,5 | — |
| 12 | s. Bsp. 6 | Na-sulfat | 3 | —″— | 1 | 2,5 | Temperatur 40°C |
| 13 | s. Bsp. 5 | NH$_4$-phosphat | 3 | ethoxylierter Isotridecylalkohol mit 8 Ethylenoxid-Einheiten | 3 | 8 | Temperatur 45°C |
| 14 | s. Bsp. 3 | Li-sulfat | 3 | Stearylammoniumchlorid/Ethylenoxid-Addukt mit 5 Ethylenoxid-Einheiten | 0,6 | 4 | — |
| 15 | s. Bsp. 2 | Al-sulfat | 3 | Na-octylsulfat | 1 | 8 | — |
| 16 | s. Bsp. 1 | Na-sulfat | 3 | —″— | 1 | 2,5 | — |
| 17 | s. Bsp. 3 | —″— | 3 | —″— | 1 | 2,5 | — |
| 18 | s. Bsp. 6 | Na-phosphat | 3 | — | — | 3—4 | Temperatur 45° bis 55°C, pH-Wert mit H$_3$PO$_4$ eingestellt |
| 19 | s. Bsp. 2 | Na-nitrat | 3 | Na-octylsulfat | 1 | 3 | — |
| 20 | s. Bsp. 11 | —″— | 3 | —″— | 1 | 2,5 | — |
| 21 | s. Bsp. 3 | Na-bromid | 3 | Na-octylsulfat | 1 | 6 | — |
| 22 | s. Bsp. 2 | Na-phosphat | 3 | — | — | 7 | pH-Wert mit H$_3$PO$_4$ eingestellt |

Tabelle

| Bsp. | Typ des Kopier-materials | wäßriger Elektrolyt | | Tensid | | pH-Wert | Bemerkungen |
|---|---|---|---|---|---|---|---|
| | | Typ | Konz. (%) | Typ | Konz. (%) | | |
| 23 | lichtempfindliche Schicht nach Bsp.1, Träger aus verchromtem Eisen | Na-hydrocarbonat | 3 | ethoxylierter Tridecylalkohol mit 8 Ethylenoxid-Einheiten | 3 | 4 | — |
| 24 | s. Bsp. 3 | Na-nitrat | 3 | Na-octylsulfat | 1 | 3 | — |
| 25 | s. Bsp. 2 | Na-bromid | 3 | —"— | 1 | 3 | — |
| 26 | s. Bsp. 23 | Na-phosphat | 3 | ethoxylierter Isotridecylalkohol mit 8 Ethylenoxid-Einheiten | 3 | 8 | — |
| 27 | s. Bsp. 3 | Li-sulfat | 3 | Na-Salz des Schwefelsäuremono(7-ethyl-2-methyl-undecyl-4) esters | 1 | 4 | — |
| 28 | s. Bsp. 2 | Na-chlorid | 3 | Na-octylsulfat | 1 | 6 | — |
| 29 | s. Bsp. 11 | Li-sulfat | 3 | —"— | 1 | 3,5 | — |
| 30 | s. Bsp. 3 | Na-chlorid | 3 | —"— | 1 | 6 | — |
| 31 | s. Bsp. 2 | Na-vanadat | 3 | —"— | 1 | 9,5 | — |
| 32 | s. Bsp. 11 | Li-sulfat | 3 | Na-Salz des Schwefelsäuremono (7-ethyl-2-methyl-undecyl-4-)esters | 1 | 4 | — |
| 33 | s. Bsp. 5 | Na-chlorid | 3 | Na-octylsulfat | 1 | 4 | leichter Oxidschichtangriff |
| 34 | s. Bsp. 2 | Na-laurylsulfat | 6 | — | — | 4 | |
| 35 | s. Bsp. 11 | Na-nitrat | 3 | Na-octylsulfat | 1 | 4 | — |
| 36 | s. Bsp. 3 | —"— | 3 | ethoxylierter Isotridecylalkohol mit 8 Ethylenoxid-Einheiten | 3 | 4 | — |
| 37 | s. Bsp. 2 | Li-sulfat | 3 | Stearylammoniumchlorid/ Ethylenoxid-Addukt mit 5 Ethyenoxid-Einheiten | 0,6 | 7 | — |
| 38 | s. Bsp. 2 | $NH_4$-phosphat | 3 | Na-decylsulfat | 1 | 9 | — |
| 39 | s. Bsp. 23 | Na-nitrat | 3 | ethoxylierter Isotridecylalkohol mit 8 Ethylenoxid-Einheiten | 3 | 4 | — |
| 40 | s. Bsp. 3 | Na-phosphat | 3 | —"— | 3 | 7—8 | pH-Wert mit $H_3PO_4$ eingestellt |
| 41 | s. Bsp. 2 | Na-phosphat | 3 | Na-octylsulfat | 1 | 7 | pH-Wert mit $H_3PO_4$ eingestellt |

Tabelle

| Bsp. | Typ des Kopier-materials | wäßriger Elektrolyt | | Tensid | | pH-Wert | Bemerkungen |
|---|---|---|---|---|---|---|---|
| | | Typ | Konz. (%) | Typ | Konz. (%) | | |
| 42 | s. Bsp. 3 | NH₄-sulfat | 3 | —"— | 1 | 3 | — |
| 43 | s. Bsp. 2 | Mg-sulfat | 3 | —"— | 1 | 6 | — |
| 44 | s. Bsp. 2 | —"— | 3 | —"— | 1 | 2,5 | pH-Wert mit H₂SO₄ eingestellt |
| 45 | s. Bsp. 2 | Na-hydrogen-carbonat | 3 | ethoxylierter Isotridecylal-kohol mit 8 Ethylenoxid-Einheiten | 3 | 8 | — |
| 46 | s. Bsp. 2 | Na-acetat | 3 | —"— | 3 | 4,5 | — |
| 47 | s. Bsp. 1 | Li-sulfat | 3 | Stearylammo-niumchlorid/ Ethylenoxid-Addukt mit 5 Ethylenoxid-Einheiten | 0,6 | 5 | — |
| 48 | s. Bsp. 2 | Na-hydrogen-carbonat | 3 | ethoxylierter Isotridecylal-kohol mit 8 Ethylenoxid-Einheiten | 3 | 4 | — |
| 49 | lichtempfindliche Schicht nach Bsp.1, Träger mit Bürsten und Schleifmittel mecha-nisch aufgerauht | Na-chlorid | 3 | —"— | 3 | 6 | — |
| 50 | s. Bsp. 2 | Na-borat | 3 | ethoxylierter Isotridecylal-kohol mit 8 Ethylenoxid-Einheiten | 3 | 3,5 | — |
| 51 | s. Bsp. 49 | Na-nitrat | 3 | —"— | 3 | 4 | — |
| 52 | s. Bsp. 2 | Na-phosphat | 3 | —"— | 3 | 7 | pH-Wert mit H₃PO₄ eingestellt, Wechselstrom 40 V, 50 Hz |
| 53 | s. Bsp. 2 | Li-sulfat | 3 | Na-octylsulfat | 1 | 3 | Wechselstrom 40 V, 50 Hz |
| 54 | s. Bsp. 3 | —"— | 3 | —"— | 1 | 3 | —"— |
| 55 | s. Bsp. 2 | —"— | 3 | —"— | 1 | 3 | Wechselstrom 0,5 Hz |
| 56 | s. Bsp. 2 | —"— | 3 | —"— | 1 | 3 | Wechselstrom 5 Hz |
| 57 | s. Bsp. 2 | —"— | 3 | —"— | 1 | 3 | Wechselstrom 500 Hz |
| 58 | s. Bsp. 2 | NH₄-phosphat | 3 | —"— | 1 | 7,5 | — |
| 59 | s. Bsp. 3 | Tetraethylam-moniumhy-droxid | 3 | ethoxylierter Isotridecylal-kohol lmit 8 Ethylenoxid-Eingheiten | 3 | 3 | pH-Wert mit H₃PO₄ eingestellt |
| 60 | s. Bsp. 3 | Borsäure | 3 | Na-octylsulfat | 1 | 2,5 | Temperatur 50°C |
| 61 | s. Bsp. 3 | Essigsäure | 3 | —"— | 1 | 2,5 | —"— |

65

## Beispiel 62

Eine elektrochemisch aufgerauhte, anodisch oxidierte und mit einer wäßrigen Polyvinylphosphonsäure-Lösung hydrophilierte Aluminiumfolie wird mit folgender negativarbeitenden lichtempfindlichen Lösung beschichtet:

2,00 Gew.-Teile eines Styrol/Maleinsäureanhydrid-Mischpolym risates (I:I, Molekulargewicht 50000), welches mit Hydroxyethylmethacrylat umgesetzt ist

2,00 Gew.-Teile eines Diurethans aus 2 Mol Glycerindimethacrylat und I Mol Hexamethylendiisocyanat

0,70 Gew.-Teile 9-Phenyl-acridin

0,07 Gew.-Teile Samaronmarineblau

32,00 Gew-Teile Butanon

12,00 Gew.-Teile Essigsäurebutylester

12,00 Gew.-Teile Ethylenglykolmonomethylether

Nach der Belichtung erfolgt die elektrochemische Entwicklung in einer wäßrigen Lösung mit einem Gehalt an 3 % Ammoniumsulfat und 1 % Natrium-octylsulfat bei einem pH-Wert von 4, bei 40 V und während 4 bis 6 sec.

## Beispiel 63

Die Platte von Beispiel 62 wird in einer wäßrigen Lösung mit einem Gehalt von 3 % Natriumnitrat und 3 % eines ethoxilierten Isotridecylalkohols mit 8 Ethylenoxid-Einheiten bei einem pH-Wert von 4 elektrochemisch entwickelt.

## Beispiel 64

Eine elektrochemisch aufgerauhte und anodisch oxidierte Aluminiumfolie wird mit einer elektrophotographischarbeitenden Lösung aus folgenden Bestandteilen beschichtet:

10,00 Gew.-Teile 2,5-Bis-(4'-diethylaminophenyl)-1'3'4-oxdiazol

10,00 Gew.-Teile eines Mischpolymerisats aus Styrol und Maleinsäureanhydrid (mit einem Erweichungspunkt von 210°C)

0,02 Gew.-Teile Rhodamin FB (C. I. 45170)

300,00 Gew.-Teile Ethylenglykolmonomethylether.

Die beschichtete Platte wird mit Hilfe einer Corona auf etwa 400V negativ aufgeladen und mit einer Filmvorlage belichtet. Das entstehende elektrostatische Bild wird durch Einstäuben mit einem durch Ruß angefärbten Harz sichtbar gemacht und durch Erwärmen auf 150°C zu einer wischfesten Elektrokopie fixiert. Die Entschichtung der bildfreien Stellen erfolgt elektrochemisch in einer wäßrigen Lösung mit einem Gehalt an 3 % Ammoniumphosphat und 3 % eines ethoxylierten Isotridecylalkohols mit 8 Ethylenoxid-Einheiten bei einem pH-Wert von 8.

## Beispiel 65

Eine verchromte Kupferfolie wird mit folgender negativarbeitenden, lichtempfindlichen Lösung beschichtet:

0,25 Gew.-Teile Polyvinylacetat (Viskosität von 2200 mPa's nach Höppler in 20 %iger Essigsäureethylester-Lösung bei 20°C)

0,75 Gew.-Teile Polyvinylacetat (40 mPa's)

4,00 Gew.-Teile Phenol-Formaldehyd-Novolak (Erweichungspunkt von 110° bis 120°C nach DIN 53 181)

1,00 Gew.-Teile Kondensationsprodukt aus Cyclohexanon und Formaldehyd (Erweichungspunkt von 75° bis 90°C)

3,00 Gew.-Teile 4-(2-Phenyl-prop-2-yl)-phenylester der Naphthochinon-(1,2)-diazid-(2)-sulfon-säure-(4)

0,20 Gew.-Teile Kristallviolett

88,80 Gew.-Teile Ethylenglykol

2,00 Gew.-Teile dest. $H_2O$

und nach der Belichtung in einer wäßriger Lösung mit einem Gehalt an 3 % Lithiumsulfat und I % Natrium-octylsulfat bei einem pH-Wert von 3 elektrochemisch entwickelt.

## Beispiel 66

Eine trockengebürstete Aluminiumfolie wird mit einer flüssigen Photoresistschicht aus folgenden Bestandteilen versehen:;

4 Gew.-Teile eines Kresol-Formaldehyd-Novolaks (Schmelzbereich 105° - 120°C nach DIN 53 181)

1 Gew.-Teil Bis-naphthochinon-1,2-diazid-5-sulfonsäureester des 4,4'-Bishydroxyphenylvalerian-säure-2-ethoxyethylesters

40 Gew.-Teile Methylethylketon

Nach der bildmäßigen Belichtung erfolgt die elektrochemische Entwicklung in einer wäßrigen Lösung mit einem Gehalt an 3 % Lithiumsulfat und I % Natrium-octylsulfat bei einem pH-Wert von 3.

## Beispiel 67

Die Platte nach Beispiel 3 wird bei einer Spannung von 30 V (Gleichstrom) während 10 sec elektrochemisch in einer wäßrigen Lösung mit einem Gehalt an 3 % Lithiumsulfat und 1 % Natrium-octylsulfat bei einem pH-Wert von 3 entwickelt. Die Stromdichte steigt zu Beginn während der ersten 5 sec auf etwa 25 A/dm² an, bleibt dann 3 sec auf diesem Wert und steigt in den letzten beiden sec wieder leicht an.

## Beispiel 68

Die Platte nach Beispiel 3 wird unter Verwendung eines Schwammtuches auf Basis von Cellulosehydrat, das mit einer wäßrigen Lösung eines Gehalts von 3 % Lithiumsulfat und 1 % Natrium-octylsulfat getränkt wurde, als Elektrolytspeicher entwickelt, wobei das getränkte Schwammtuch zwischen einer Graphitelektrode und der zu entwickelnden Platte angeordnet wird. Die Entwicklung der Platte wird bei einem pH-Wert von 3, einer Spannung von 15 V und während 3 bis 6 sec durchgeführt.

## Patentansprüche

1. Verfahren zum Entwickeln von belichteten lichtempfindlichen Reproduktionsschichten mit einem Entwickler auf der Basis eines wäßrigen Elektrolyten, dadurch gekennzeichnet, daß die die Nichtbildstellen ergebenden Schichtteile durch elektrochemische Behandlung mit einem Gleich- oder Wechselstrom einer Stromdichte von 1 bis 100 A/dm$^2$ und bei einer Temperatur von 20° bis 70° entfernt werden, wobei der pH-Wert des wäßrigen Elektrolyten auf einen Bereich von 2,0 bis 10,0 eingestellt wird und der Elektrolyt mindestens ein Salz einer organischen oder anorganischen Säure in einer Konzentration von 0,1 Gew.-% bis zur Sättigungsgrenze der Lösung an dem jeweiligen Salz oder Säuren enthält.

2. Verfahren nach Anspruch 1 dadurch gekennzeichnet, daß der wäßrige Elektrolyt ein Tensid in einer Konzentration von 0,1 bis 5 Gew.-% enthält.

3. Verfahren nach einem der Ansprüche 1 oder 2, dadurch gekennzeichnet, daß die zu entwickelnde Reproduktionsschicht als Teil eines Kopiermaterials mit einem elektrisch leitfähige Trägermaterial vorliegt.

4. Verfahren nach Anspruch 3, dadurch gekennzeichnet, daß die zu entwickelnde Reproduktionsschicht als Teil einer Offsetdruckplatte oder als auf ein Trägermaterial aufgebrachter Photoresist vorliegt.

## Claims

1. A process for developing exposed light-sensitive reproduction layers using a developer based on an aqueous electrolyte, wherein those parts of the layer which produce the non-image areas are removes by electrochemical treatment With a direct or alternating current of a current density of 1 to 100 A/dm$^2$ and at a temperature of 20° to 70°C, the pH value of the aqueous electrolyte being adjusted Within a range of 2.0 to 10.0 and the electrolyte containing at least one salt of an organic or inorganic acid, in a concentration from 0.1 % by weight up to the saturation limit of the solution for the particular salt,or acids.

2. The process as claimed in claim 1, whereinthe aqueous electrolyte contains a surfactant in a concentration of 0.1 to 5% by weight.

3. The process as claimed in claim 1 or claim2, wherein the reproduction layer to be developed is present as part of a copying material with an electrically conductive support material.

4. The process as claimed in claim 3, wherein the reproduction layer to be developed is present as part of an off set printing plate or as a photoresist applied to a support material.

## Revendications

1. Procédé de développement de couches de reproduction photosensibles exposées avec un développateur à base d'un électrolyte aqueux, caractérisé en ce que les parties de la couche donnant les parties non image sont éliminées par traitement électrochimique par un courant continu ou alternatif d'une densité de courant de 1 à 100 A/dm$^2$, à une température de 20 à 70°C, le pH de l'electrolyte aqueux étant ajusté dans un intervalle de 2,0 à 10,0, et en ce que l'électrolyte contient au moins un sel d'un acide organique ou minéral à une concentration allant de 0,1 % en poids jusqu'à la limite de saturation de la solution en le sel particulier ou des acides.

2. Procédé selon la revendication 1, caractérisé en ce que l'électrolyte aqueux contient un tensioactif à une concentration de 0,1 à 5 % en poids.

3. Procédé selon la revendication 1 ou 2, caractérisé en ce que la couche de reproduction à développer constitue une partie d'un matériau pour reprographie avec un matériau support électroconducteur.

4. Procédé selon la revendication 3, caractérisé en ce que la couche de reproduction à développer constitue une partie d'une plaque d'impression offset ou constitue un photorésist appliqué sur un matériau support.